# EUROPÄISCHE PATENTSCHRIFT

(11) **EP 1 630 914 B1**
(45) Veröffentlichungstag und Bekanntmachung des Hinweises auf die Patenterteilung: **12.03.2008**
(21) Anmeldenummer: 05016990.3
(22) Anmeldetag: 04.08.2005
(51) Int. Cl.: H01S 5/183, H01S 5/14

(54) **Vertikal emittierender Halbleiterlaser mit externem Resonator und Verfahren zu dessen Herstellung**
Vertically emitting semiconductor laser with external resonator and its method of fabrication
Laser sémi-conducteur à émission verticale et à cavité externe et son procédé de fabrication

(30) Priorität: 31.08.2004 DE 102004042510
(43) Veröffentlichungstag der Anmeldung: 01.03.2006
(73) Patentinhaber: Osram Opto Semiconductors GmbH, 93049 Regensburg (DE)
(72) Erfinder: Schmid, Wolfgang, 93180 Deuerling / Hillohe (DE); Streubel, Klaus, 93164 Laaber (DE); Linder, Norbert, 93173 Wenzenbach (DE)
(74) Vertreter: Epping - Hermann - Fischer

(56) Entgegenhaltungen:
- WO-A-20/04064211
- US-A- 5 291 502
- US-A- 5 994 723
- US-A1- 2003 022 406
- US-A1- 2003 123 495
- US-A1- 2003 185 267

## Beschreibung

Die vorliegende Erfindung bezieht sich auf einen vertikal emittierenden Halbleiterlaser nach dem Oberbegriff des Patentanspruchs 1 sowie ein Verfahren zu dessen Herstellung.

Ein gattungsgemäßer strahlungsemittierender Halbleiterlaser ist beispielsweise aus der Druckschrift WO 02/13334 A2 bekannt. Hierin ist ein vertikal emittierender Laser in Form eines sogenannten VCSEL (Vertical Cavity Surface Emitting Laser) beschrieben. Dieser VCSEL weist einen Halbleiterkörper mit einem von zwei Resonatorspiegeln gebildeten Laserresonator auf, wobei in dem Laserresonator unter anderem eine aktive Schicht und eine Stromeinschnürungsschicht angeordnet sind. Die Stromeinschnürungsschicht dient im Betrieb zur Konzentration des Betriebsstroms auf einen kleinen Teilbereich der aktiven Schicht, um dort die für den Laserbetrieb erforderliche Besetzungsinversion zu erzeugen.

Derartige oberflächenemittierende VCSEL zeichnen durch eine hohe Strahlqualität aus, besitzen aber eine vergleichsweise geringe optische Ausgangsleistung. Zudem ist, wie in der oben genannten Druckschrift beschrieben, auf eine wohldefinierte Stromführung zu achten, da ansonsten aufgrund der Nähe von Strompfad und Laserresonatorvolumen in Verbindung mit den vergleichsweise geringen lateralen Ausdehnungen eines solchen Halbleiterlasers die elektrische Verlustwärme die Strahlqualität beziehungsweise die Stabilität negativ beeinflussen könnte.

In der Druckschrift US 5,994,723 ist beschrieben, innerhalb eines Halbleiterkörpers mit einer npnp-Schichtenfolge einen Teilbereich der oberen n-dotierten Schicht durch Eindiffundieren eines p-Dotiertstoffs p-leitend zu machen, um einen Stromfluss durch den Halbleiterkörper in diesem Teilbereich des Halbleiterkörpers zu ermöglichen.

Ferner beschreibt die Druckschrift US2003/0185267 einen VCSEL, bei dem der Stromfluss mittels zweier n-dotierter Stromblenden, die innerhalb einer p-dotierten Schicht ausgebildet sind, auf einen zentralen Bereich des VCSELs eingeschränkt wird. Die Stromblenden haben einen von dem zentralen Bereich verschiedenen Brechungsindex und unterdrücken daher gleichzeitig höhere Moden des Lasers.

Weiterhin ist bekannt, zur Steigerung der optischen Ausgangsleistung statt eines in den Halbleiterkörper integrierten Laserresonators einen Resonator mit einem externen Resonatorspiegel vorzusehen. Derartige Vorrichtungen werden auch als VECSEL (Vertical External Cavity Surface Emitting Laser) bezeichnet. Solche Halbleiterlaser mit einem externen Resonator weisen üblicherweise eine sehr viel größere laterale Ausdehnung als ein VCSEL auf und werden mit entsprechend höheren Leistungen betrieben. So liegt typischerweise der Durchmesser eines VECSELs im Bereich von 10 µm oder sogar darüber. Aufgrund der stark unterschiedlichen lateralen Dimensionierung sind in der Regel die Konzepte zur Führung des Betriebsstroms bei einen VCSEL nicht auf einen VECSEL übertragbar.

Es ist Aufgabe der vorliegenden Erfindung, einen vertikal emittierenden Halbeiterlaser mit einem Halbleiterkörper mit hoher Ausgangsleistung und einer verbesserten Stromführung zu schaffen. Ferner soll der Halbleiterkörper des vertikal emittierenden Halbleiterlasers mit geringem technischem Aufwand herstellbar sein. Weiterhin ist es Aufgabe der vorliegenden Erfindung, ein Herstellungsverfahren für einen erfindungsgemäßen vertikal emittierenden Halbliterlaser anzugeben.

Diese Aufgabe wird durch einen vertikal emittierenden Halbleiterlaser gemäß Patentanspruch 1 sowie ein Herstellungsverfahren gemäß Patentanspruch 8 gelöst. Vorteilhafte Weiterbildungen der Erfindung sind Gegenstand der abhängigen Ansprüche.

Ein erfindungsgemäßer vertikal emittierender Halbleiterlaser mit externem Resonator umfasst einen strahlungsemittierenden Halbleiterkörper mit vertikaler Emissionsrichtung, der eine innerhalb des Halbleiterkörpers angeordnete Stromführungsschicht mit einem Stromsperrbereich und einem Stromdurchlassbereich sowie eine strahlungserzeugende aktive Schicht aufweist, wobei der externe Resonator ein vorgegebenes Resonatorvolumen aufweist, das mit dem Stromdurchlassbereich überlappt.

Durch die Anpassung der Stromführungsschicht an das durch den externen Resonator vorgegebene Resonatorvolumen wird der Betriebsstrom zu einem für die Strahlungserzeugung innerhalb des Resonatorvolumens zweckmäßigen Bereich in dem Halbleiterkörper hingeführt. Hierdurch wird eine Einkopplung des Betriebsstroms über einen außerhalb des Resonatorvolumens angeordneten elektrischen Kontakt ermöglicht, so dass einerseits dieser Kontakt die Strahlungsauskopplung nicht behindert und andererseits eine vorteilhafte Stromführung für einen effizienten Laserbetrieb gewährleistet ist.

Entsprechend ist bei einer bevorzugten Ausführungsform der vorliegenden Erfindung bei dem Halbleiterkörper eine Strahlungsaustrittsseite und auf der Strahlungsaustrittsseite ein vorgegebener Strahlungsaustrittsbereich vorgesehen, wobei außerhalb dieses Strahlungsaustrittsbereichs ein elektrischer Kontakt zur Einprägung des Betriebsstroms in den Halbleiterkörper angeordnet ist. Bevorzugt ist der Stromsperrbereich der Stromführungsschicht dem elektrischen Kontakt in vertikaler Richtung nachgeordnet, so dass ein Stromfluss außerhalb des Resonatorvolumens des externen Resonators, der zur Strahlungserzeugung nicht oder nur in ineffizienter Weise beiträgt, vermieden wird.

Der Stromsperrbereich ist bei einer vorteilhaften Weiterbildung der vorliegenden Erfindung mittels mindestens eines im Betrieb sperrenden pn-Übergangs gebildet. Derartige sperrende pn-Übergänge können mit vergleichsweise geringem technischen Aufwand hergestellt werden.

Die Stromführungsschicht ist zwischen zwei Mantelschichten eines ersten Leitungstyps angeordnet und weist in dem Stromsperrbereich einen zweiten Leitungstyp auf. Bei dieser Anordnung bildet die Stromführungsschicht in dem Stromsperrbereich in Verbindung mit den benachbarten Mantelschichten jeweils einen pn-Übergang, wobei die Durchlassrichtungen dieser pn-Übergänge einander entgegengesetzt sind und somit einen Stromfluss durch den Stromsperrbereich verhindern. In dem Stromdurchlassbereich weist hingegen die Stromführungsschicht den ersten Leitungstyp auf, so dass in diesem Bereich keine sperrenden pn-Übergänge angeordnet sind.

Die Stromführungsschicht ist in dem Stromdurchlassbereich mit Dotierstoffen des ersten und des zweiten Leitungstyps dotiert. Dies erleichtert die Herstellung eines entsprechenden Halbleiterkörpers, da zunächst die Stromführungsschicht durchgehend mit Dotierstoffen des zweiten Leitungstyps dotiert werden kann. Nachfolgend wird gezielt in dem Stromdurchlassbereich die Stromführungsschicht mit einem Dotierstoff des ersten Leitungstyps derart dotiert, dass die Dotierung des ersten Leitungstyps überwiegt und der Leitungstyp umgekehrt wird, so dass insgesamt der Stromdurchlassbereich den ersten Leitungstyp aufweist.

Bei einer vorteilhaften Ausgestaltung der vorliegenden Erfindung ist in dem Halbleiterkörper weiterhin eine Spiegelstruktur zur Bildung des externen Resonators angeordnet. Die Spiegelstruktur kann beispielsweise als Bragg-Spiegel ausgebildet sein. Dies erleichtert den Aufbau des externen Resonators, da zusätzlich zu dem Halbleiterkörper nur noch ein externer Spiegel erforderlich ist.

Vorzugsweise ist der externe Resonatorspiegel ein konkav gekrümmter Spiegel, durch den weiter bevorzugt die Laserstrahlung ausgekoppelt wird. Bei geeigneter Dimensionierung des Krümmungsradius zur Resonatorlänge weist ein derartiger Resonator gegenüber einem Fabry-Perot-Resonator mit planen Resonatorspiegeln eine vorteilhaft erhöhte Stabilität auf.

Zur Herstellung eines erfindungsgemäßen vertikal emittierenden Halbleiterlasers wird bei der vorliegenden Erfindung der Halbleiterkörper mittels eines Epitaxieverfahrens gefertigt, wobei nacheinander eine erste Mantelschicht eines ersten Leitungstyps, die Stromführungsschicht eines zweiten Leitungstyps und eine zweite Mantelschicht des ersten Leitungstyps aufgewachsen wird, und nachfolgend die Stromführungsschicht innerhalb des Stromdurchlassbereichs mit einem Dotierstoff derart dotiert wird, dass der Stromdurchlassbereich den ersten Leitungstyp aufweist.

Ein derartiges Herstellungsverfahren erfordert einen vergleichsweise geringen technischen Aufwand, da zusätzlich zum epitaktischen Aufwachsen der Halbleiterschichten nur eine strukturierte Diffusion innerhalb der Stromdurchlassbereichs erforderlich ist.

Bevorzugt wird zur Dotierung des Stromdurchlassbereichs eine Dotierstoffquelle mit dem entsprechenden Dotierstoff strukturiert auf die zweite Mantelschicht in einem Bereich aufgebracht, dem der Stromdurchlassbereich in vertikaler Richtung nachgeordnet ist und nachfolgend der Dotierstoff in den Stromdurchlassbereich diffundiert. Nach dem Diffusionsprozess kann die Dotierstoffquelle wieder entfernt werden.

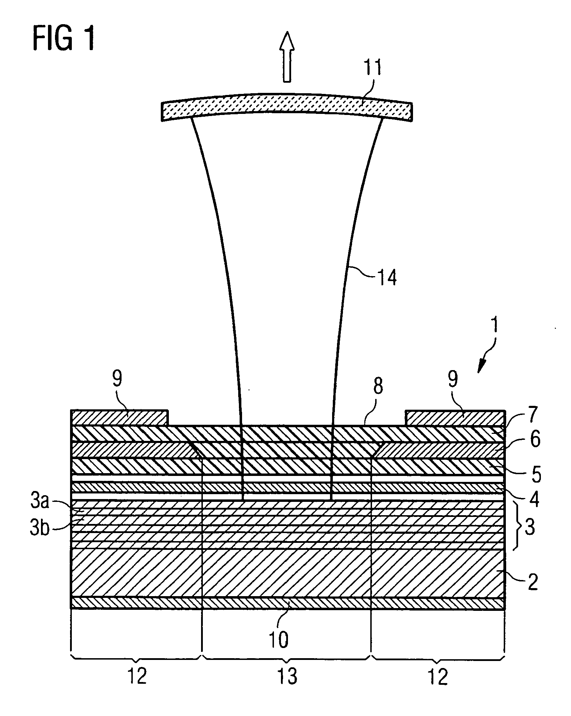

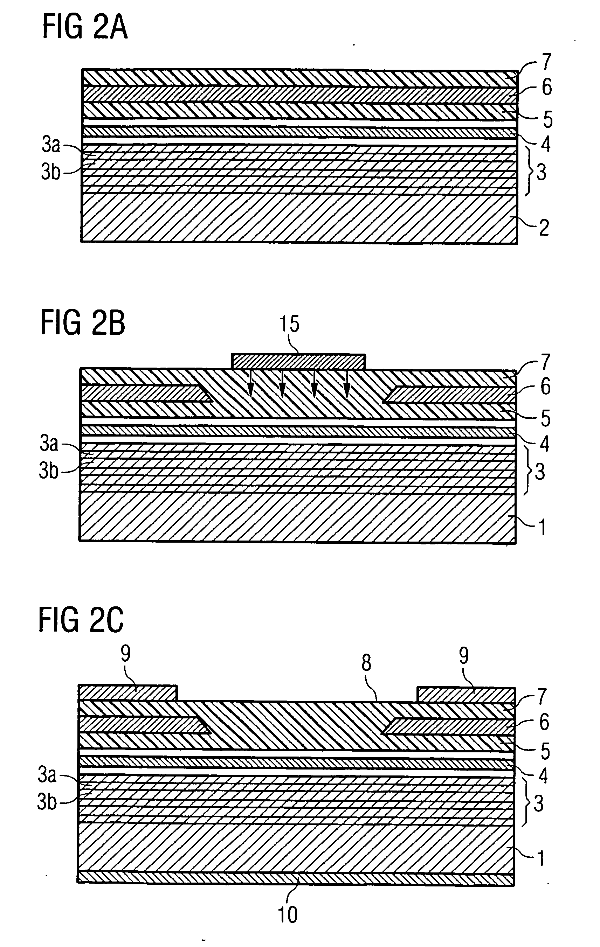

Weitere Merkmale, Vorzüge und Zweckmäßigkeiten der Erfindung ergeben sich aus der nachfolgenden Beschreibung von zwei Ausführungsbeispielen in Verbindung mit den Figuren 1 und 2.

Es zeigen:
Figur 1 eine schematische Schnittansicht eines Ausführungsbeispiels eines Halbleiterkörpers eines erfindungsgemäßen Halbleiterlasers und
Figur 2 eine schematische Darstellung eines Ausführungsbeispiels eines erfindungsgemäßen Herstellungsverfahrens anhand von drei Zwischenschritten.

Gleiche oder gleichwirkende Elemente sind in den Figuren mit den selben Bezugszeichen versehen.

Das in Figur 1 dargestellte Ausführungsbeispiel weist einen Halbleiterkörper 1 auf, der in vertikaler Richtung gesehen eine Substrat 2, eine Spiegelschicht 3, eine aktive Schicht 4, eine erste Mantelschicht 5, eine Stromführungsschicht 6 und eine zweite Mantelschicht 7 umfasst. Auf der Strahlungsauskopplungsseite 8 des Halbleiterkörpers ist ein erster elektrischer Kontakt 9, vorzugsweise in Form eines Ringkontakts, ausgebildet. Korrespondierend ist auf der gegenüberliegenden Seite des Halbleiterkörpers ein durchgehender elektrischer Kontakt 10 angeordnet.

Der Laserresonator wird von der Spiegelschicht 3 und einem externen Spiegel 11, bevorzugt mit gekrümmter Spiegelfläche, gebildet. Die Spiegelschicht 3 kann in an sich bekannter Weise als Bragg-Spiegel mit einer Mehrzahl alternierender Halbleiterschichten mit unterschiedlichem Brechungsindex ausgeführt sein. Als Materialsystem für derartige Schichten eignet sich beispielsweise GaAs/AlGaAs, wobei die Schichtfolge sich aus Schichtpaaren 3a, 3b mit unterschiedlichem Aluminiumgehalt zusammensetzt. Alternativ kann als Spiegelstruktur 3 auch ein Metallspiegel oder ein dielektrischer Spiegel vorgesehen sein, wobei in diesem Fall das Substrat 2 zweckmäßigerweise entfallen kann. Weitergehend kann im Fall eines Metallspiegels dieser Spiegel zugleich als Kontakt 10 verwendet werden.

Die Stromführungsschicht 6 ist zwischen zwei Mantelschichten 5 und 7 eines ersten Leitungstyps angeordnet und weist in dem Stromdurchlassbereich 13 ebenfalls den ersten Leitungstyp auf. In den Stromsperrbereichen 12 hingegen weist die Stromführungsschicht 6 einen zweiten Leitungstyp auf, so dass in vertikaler Richtung gesehen zusammen mit den angrenzenden Mantelschichten 5 und 7 zwei pn-Übergänge mit entgegengesetzter Durchlassrichtung gebildet sind, die einen vertikalen Stromfluss im Stromsperrbereich 12 verhindern.

Beispielsweise kann als Substrat 2 ein n-dotiertes GaAs-Substrat vorgesehen sein, auf das ein n-dotierter GaAs/AlGaAs Bragg-Spiegel aufgewachsen ist.

Die aktive Schicht 4 ist bevorzugt als Einfach- oder Mehrfachquantentopstruktur (SQW - single quantum well bzw. MQW - multiple quantum well)ausgeführt. Derartige Quantentopfstrukturen weisen in der Regel eine (SQW) bzw. mehrere (MQW) Quantentopfschichten auf, die zwischen Barriereschichten angeordnet sind. Beispielsweise können die Quantentopfstrukturen InGaP-, InGaAs- oder GaAs-Quantentopfschichten und/oder AlInGaP- beziehungsweisew AlGaAs-Barriereschichten enthalten. Weiterhin können zwischen den einzelnen Quantentöpfen Spacerschichten vorgesehen sein.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Ferner eignet sich als aktive Schicht 4 beispielsweise eine p-dotierte InGaP-Schicht, die zwischen zwei AlGaInP-Schichten eingebettet ist.

Hierauf folgt in vertikaler Richtung gesehen eine p-dotierte erste Mantelschicht 5, eine in den Stromsperrbereichen 12 n-dotierte und in dem Stromdurchlassbereich 13 p-dotierte Stromführungsschicht 6 und eine p-dotierte zweite Mantelschicht 7. Diese drei Halbleiterschichten 5, 6 und 7 können beispielsweise AlGaAs oder AlGaInP enthalten. Damit wird in den Stromsperrbereichen 12 ein sperrender npn-Übergang, also eine Serienschaltung zweier entgegengesetzter pn-Übergänge, gebildet.

Die laterale Breite des Stromdurchlassbereichs 13 ist bei der Erfindung so gewählt, dass der Stromdurchlassbereich mit dem vorgegeben Resonatorvolumen 14 des externen Resonators überlappt, wobei bevorzugt der Stromdurchlassbereich breiter ist als der laterale Querschnitt des Resonatorvolumens 14 im Bereich der Stromführungsschicht 6. Das Resonatorvolumen wird bei dem gezeigten Ausführungsbeispiel insbesondere durch die Resonatorlänge in Verbindung mit dem Krümmungsradius des externen Spiegels 11 festgelegt. Im Zweifel kann als Resonatorbegrenzung bei der vorliegenden Erfindung der 1/e²-Radius des elektromagnetischen Grundmodenfeldes in Gausscher Näherung herangezogen werden.

In den Figuren 2a, 2b und 2c ist anhand von drei Zwischenschritten ein erfindungsgemäßes Herstellungsverfahren für den in Figur 1 gezeigten Halbleiterkörper dargestellt.

In einem ersten Schritt, Figur 2a, wird auf ein Substrat 2 zunächst eine Spiegelstruktur 3 mit einer Abfolge von Schichtpaaren 3a, 3b mit verschiedenem Brechungsindex, eine aktive Schicht 4, eine erste Mantelschicht 5, eine Stromführungsschicht 6 und eine zweite Mantelschicht 7 epitaktisch aufgewachsen. Hierbei weist die erste Mantelschicht 5 durchgehend einen ersten Leitungstyp, die Stromführungsschicht 6 durchgehend einen zweiten Leitungstyp und die zweite Mantelschicht 7 durchgehend den ersten Leitungstyp auf. Beispielsweise kann die erste Mantelschicht 5 p-dotiert sein, die Stromführungsschicht 6 n-dotiert und die zweite Mantelschicht 7 wiederum p-dotiert sein.

In einem zweiten Schritt, Figur 2b, werden der Stromsperrbereich 12 und der Stromdurchlassbereich 13 der Stromführungsschicht 6 ausgebildet. Hierzu wird auf die zweite Mantelschicht 7 eine Dotierstoffquelle 15 strukturiert in einem Bereich aufgebracht, dem der Stromdurchlassbereich 13 in vertikaler Richtung nachgeordnet ist. Die Dotierstoffquelle 15 enthält einen Dotierstoff des ersten Leitungstyps, der nachfolgend in die darunterliegenden Schichten und insbesondere in die Stromführungsschicht 6 eindiffundiert wird. Die Dotierung erfolgt dabei derart, dass in dem Stromdurchlassbereich 13 der Stromführungsschicht 6 der Leitungstyp umgekehrt wird. Auf diese Art und Weise entsteht in dem Stromdurchlassbereich ein vertikaler Strompfad des ersten Leitungstyps. Als Dotierstoff für die oben genannten Halbleitermaterialien eignet sich beispielsweise Zink.

In einem dritten Schritt, Figur 2c, werden nachfolgend auf die Strahlungsauskopplungsseite 8 des Halbleiterkörpers ein elektrischer Kontakt 9, beispielsweise eine Ringkontakt, und auf der gegenüberliegenden Seite des Halbleiterkörpers ein hierzu korrespondierender durchgehender elektrischer Kontakt 10 ausgebildet. Der Ringkontakt ist hierbei so angeordnet, dass die Ringöffnung dem Stromdurchlassbereich 13 in vertikaler Richtung nachgeordnet ist. Auf diese Weise wird sichergestellt, dass der Kontakt 9 nicht in das vorgesehene Resonatorvolumen eingreift und die Strahlungsauskopplung aus dem Halbleiterkörper nachteilig beeinflusst.

Die Erläuterung der Erfindung anhand der Ausführungsbeispiele ist nicht als Beschränkung der Erfindung hierauf zu verstehen. Insbesondere ist die vorliegende Erfindung nicht auf die genannten Halbleitermaterialien beschränkt, so dass die Schichten des Halbleiterkörpers auch ein anderes Material wie etwa InₓAl_{y}Ga_{1-x-y}As mit 0≤x≤1, 0≤y≤1 und 0≤x+y≤1,
InₓAl_{y}Ga_{1-x-y}P mit 0≤x≤1, 0≤y≤1 und 0≤x+y≤1,
InₓAl_{y}Ga_{1-x-y}N mit 0≤x≤1, 0≤y≤1 und 0≤x+y≤1,
InₓAl_{y}Ga_{1-x-y}AsᵤN₁₋ᵤ mit 0≤x≤1, 0≤y≤1, 0≤x+y≤1 und 0≤u≤1,
InₓAl_{y}Ga_{1-x-y}AsᵤP₁₋ᵤ mit 0≤x≤1, 0≤y≤1, 0≤x+y≤1 und 0≤u≤1, und/oder
InₓAl_{y}Ga_{1-x-y}PᵤN₁₋ᵤ mit 0≤x≤1, 0≤y≤1, 0≤x+y≤1 und 0≤u≤1 enthalten können.

## Patentansprüche

1. Vertikal emittierender Halbleiterlaser mit einem externen Resonator,
mit einem strahlungsemittierenden Halbleiterkörper (1) mit vertikaler Emissionsrichtung, umfassend eine strahlungserzeugende aktive Schicht (4) und eine Stromführungsschicht(6) mit einem Stromsperrbereich (12) und einem Stromdurchlassbereich (13), wobei
- die Stromführungsschicht (6) zwischen zwei Mantelschichten (5, 7) eines ersten Leitungstyps angeordnet ist und in dem Stromsperrbereich (12) einen zweiten Leitungstyp aufweist,
- die Stromführungsschicht (6) in dem Stromdurchlassbereich (13) den ersten Leitungstyp aufweist, und
- der externe Resonator ein vorgegebenes Resonatorvolumen (14) aufweist, das mit dem Stromdurchlassbereich (13) überlappt, **dadurch gekennzeichnet, dass** die Stromführungsschicht (6) in dem Stromdurchlassbereich (13) mit Dotierstoffen des ersten und des zweiten Leitungstyps dotiert ist.

2. Vertikal emittierender Halbleiterlaser (1) nach Anspruch 1,
**dadurch gekennzeichnet, dass**
der Halbleiterkörper (1) eine Strahlungsaustrittseite (8) und einen auf der Strahlungsaustrittsseite (8) vorgegebenen Strahlungsaustrittsbereich aufweist, wobei außerhalb des Strahlungsaustrittsbereichs ein elektrischer Kontakt (9) angeordnet ist.

3. Vertikal emittierender Halbleiterlaser (1) nach Anspruch 2,
**dadurch gekennzeichnet, dass**
der Stromsperrbereich (12) dem elektrischen Kontakt (9) in vertikaler Richtung nachgeordnet ist.

4. Vertikal emittierender Halbleiterlaser (1) nach einem der Ansprüche 1 bis 3,
**dadurch gekennzeichnet, dass**
der Stromsperrbereich (12) mittels mindestens eines im Betrieb sperrenden pn-Übergangs gebildet ist.

5. Vertikal emittierender Halbleiterlaser (1) nach einem der Ansprüche 1 bis 4,
**dadurch gekennzeichnet, dass**
in dem Halbleiterkörper (1) eine Spiegelstruktur (3) zur Bildung des externen Resonators ausgebildet ist.

6. Vertikal emittierender Halbleiterlaser (1) nach Anspruch 5,
**dadurch gekennzeichnet, dass**
die Spiegelstruktur (3) ein Bragg-Spiegel ist.

7. Vertikal emittierender Halbleiterlaser (1) nach einem der Ansprüche 1 bis 6,
**dadurch gekennzeichnet, dass**
der externe Resonator einen gekrümmten externen Spiegel (11) aufweist.

8. Herstellungsverfahren eines vertikal emittierenden Halbleiterlasers nach einem der Ansprüche 1 bis 7 mit den Schritten
- Bereitstellen eines Aufwachssubstrats,
- epitaktisches Aufwachsen der aktiven Schicht (4), und
- Ausbilden der Stromführungsschicht,
**dadurch gekennzeichnet, dass**
die Stromführungsschicht ausgebildet wird durch die Schritte:
- Aufwachsen einer ersten Mantelschicht (5) eines ersten Leitungstyps,
- Aufwachsen der Stromführungsschicht (6) eines zweiten Leitungstyps,
- Aufwachsen einer zweiten Mantelschicht (7) des ersten Leitungstyps, und
- Dotieren der Stromführungsschicht (6) innerhalb des Stromdurchlassbereichs (13) mit einem Dotierstoff derart, dass der Stromdurchlassbereich (13) den ersten Leitungstyp aufweist.

9. Herstellungsverfahren nach Anspruch 8,
**dadurch gekennzeichnet, dass**
zur Dotierung der Stromführungsschicht (6) auf die zweite Mantelschicht (7) eine Dotierstoffquelle (15) mit dem Dotierstoff strukturiert in einem Bereich aufgebracht wird, dem der Stromdurchlassbereich (13) in vertikaler Richtung nachgeordnet ist, und nachfolgend der Dotierstoff in denm Stromdurchlassbereich (13) diffundiert.

10. Herstellungsverfahren nach Anspruch 9,
**dadurch gekennzeichnet, dass**
nach der Diffusion des Dotierstoffs die Dotierstoffquelle (15) entfernt wird.

11. Herstellungsverfahren nach Anspruch 9 oder 10,
**dadurch gekennzeichnet, dass**
der Dotierstoff Zink ist.

## Claims

1. Vertically emitting semiconductor laser with an external resonator,
having a radiation-emitting semiconductor body (1) with a vertical emission direction, comprising a radiation-generating active layer (4) and a current-carrying layer (6) with a current blocking region (12) and a current transmission region (13), wherein
- the current-carrying layer (6) is arranged between two cladding layers (5, 7) of a first conduction type and has a second conduction type in the current blocking region (12),
- the current-carrying layer (6) has the first conduction type in the current transmission region (13) and
- the external resonator has a predetermined resonator volume (14) that overlaps the current transmission region (13),
**characterized in that**
the current-carrying layer (6) is doped with dopants of the first and of the second conduction type in the current transmission region (13).

2. Vertically emitting semiconductor laser (1) according to Claim 1,
**characterized in that**
the semiconductor body (1) has a radiation exit side (8) and a radiation exit region that is predetermined on the radiation exit side (8), wherein an electrical contact (9) is arranged outside the radiation exit region.

3. Vertically emitting semiconductor laser (1) according to Claim 2,
**characterized in that**
the current blocking region (12) is disposed downstream of the electrical contact (9) in a vertical direction.

4. Vertically emitting semiconductor laser (1) according to one of Claims 1 to 3,
**characterized in that**
the current blocking region (12) is formed by means of at least one pn junction that effects blocking during operation.

5. Vertically emitting semiconductor laser (1) according to one of Claims 1 to 4,
**characterized in that**
a mirror structure (3) for forming the external resonator is formed in the semiconductor body (1).

6. Vertically emitting semiconductor laser (1) according to Claim 5,
**characterized in that**
the mirror structure (3) is a Bragg mirror.

7. Vertically emitting semiconductor laser (1) according to one of Claims 1 to 6,
**characterized in that**
the external resonator has a curved external mirror (11).

8. Method for fabricating a vertically emitting semiconductor laser according to one of Claims 1 to 7, comprising the steps of
- providing a growth substrate,
- epitaxially growing the active layer (4), and
- forming the current-carrying layer,
**characterized in that**
the current-carrying layer is formed by the steps of:
- growing a first cladding layer (5) of a first conduction type,
- growing the current-carrying layer (6) of a second conduction type,
- growing a second cladding layer (7) of the first conduction type, and
- doping the current-carrying layer (6) within the current transmission region (13) with a dopant in such a way that the current transmission region (13) has the first conduction type.

9. Fabrication method according to Claim 8,
**characterized in that**
for the doping of the current-carrying layer (6), a dopant source (15) with the dopant is applied to the second cladding layer (7) in patterned fashion in a region downstream of which the current transmission region (13) is disposed in a vertical direction, and the dopant subsequently diffuses into the current transmission region (13).

10. Fabrication method according to Claim 9,
**characterized in that**
the dopant source (15) is removed after the diffusion of the dopant.

11. Fabrication method according to Claim 9 or 10,
**characterized in that**
the dopant is zinc.

## Revendications

1. Laser à semiconducteur à émission verticale avec un résonateur externe, muni d'un corps en semiconducteur (1) émettant un rayonnement au sens d'émission vertical, comprenant une couche active (4) génératrice de rayonnement et une couche de guidage de courant (6) munie d'une zone de blocage du courant (12) et d'une zone de passage du courant (13), la couche de guidage de courant (6) étant disposée entre deux couches d'enveloppe (5, 7) d'un premier type de conducteur et présentant dans la zone de blocage du courant (12) un deuxième type de conducteur, la couche de guidage de courant (6) présentant le premier type de conducteur dans la zone de passage du courant (13) et le résonateur externe présentant un volume de résonateur (14) prédéfini qui chevauche la zone de passage du courant (13), **caractérisé en ce que** la couche de guidage de courant (6) est dopée dans la zone de passage du courant (13) avec des matériaux de dopage du premier et du deuxième type de conducteur.

2. Laser à semiconducteur (1) à émission verticale selon la revendication 1, **caractérisé en ce que** le corps en semiconducteur (1) présente un côté de sortie du rayonnement (8) et une zone de sortie du rayonnement prédéfinie sur le côté de sortie du rayonnement (8), un contact électrique (9) étant disposé à l'extérieur de la zone de sortie du rayonnement.

3. Laser à semiconducteur (1) à émission verticale selon la revendication 2, **caractérisé en ce que** la zone de blocage du courant (12) est disposée après le contact électrique (9) dans le sens vertical.

4. Laser à semiconducteur (1) à émission verticale selon l'une des revendications 1 à 3, **caractérisé en ce que** la zone de blocage du courant (12) est formée au moyen d'au moins une jonction PN bloquée en fonctionnement.

5. Laser à semiconducteur (1) à émission verticale selon l'une des revendications 1 à 4, **caractérisé en ce qu'**une structure en miroir (3) destinée à former le résonateur externe est façonnée dans le corps en semiconducteur (1).

6. Laser à semiconducteur (1) à émission verticale selon la revendication 5, **caractérisé en ce que** la structure en miroir (3) est un miroir de Bragg.

7. Laser à semiconducteur (1) à émission verticale selon l'une des revendications 1 à 6, **caractérisé en ce que** le résonateur externe présente un miroir externe (11) incurvé.

8. Procédé de fabrication d'un laser à semiconducteur à émission verticale selon l'une des revendications 1 à 7, comprenant les étapes suivantes :
- Mise à disposition d'un substrat de croissance,
- Croissance épitactique de la couche active (4) et
- Façonnage de la couche de guidage du courant, **caractérisé en ce que** la couche de guidage du courant est façonnée par les étapes suivantes :
- Croissance d'une première couche d'enveloppe (5) d'un premier type de conducteur,
- Croissance de la couche de guidage du courant (6) d'un deuxième type de conducteur,
- Croissance d'une deuxième couche d'enveloppe (7) du premier type de conducteur et
- Dopage de là couche de guidage du courant (6) à l'intérieur de la zone de passage du courant (13) avec un matériau de dopage de telle sorte que la zone de passage du courant (13) présente le premier type de conducteur.

9. Procédé de fabrication selon la revendication 8, **caractérisé en ce que** pour doper la couche de guidage du courant (6), une source de matériau de dopage (15) comportant le matériau de dopage est appliquée de manière structurée sur la deuxième couche d'enveloppe (7) dans une zone qui est disposée à la suite de la zone de passage du courant (13) dans le sens vertical et le matériau de dopage se diffuse ensuite dans la zone de passage du courant (13).

10. Procédé de fabrication selon la revendication 9, **caractérisé en ce que** la source de matériau de dopage (15) est retirée après la diffusion du matériau de dopage.

11. Procédé de fabrication selon la revendication 9 ou 10, **caractérisé en ce que** le matériau de dopage est du zinc.
